# EUROPÄISCHE PATENTSCHRIFT

(11) **EP 2 802 200 B1**
(45) Veröffentlichungstag und Bekanntmachung des Hinweises auf die Patenterteilung: **07.12.2016**
(21) Anmeldenummer: 14000701.4
(22) Anmeldetag: 27.02.2014
(51) Int. Cl.: H05K 9/00, G12B 17/02, H01R 103/00, H04B 1/3827, H04B 1/3888, H01R 24/52

(54) **Hochfrequenzdichtes Gehäuse, insbesondere hochfrequenzdichte Antennendose**
High frequency-proof case, in particular high frequency-proof antenna socket
Boîtier avec blindage contre les hautes fréquences, en particulier prise d'antenne avec blindage contre les hautes fréquences

(30) Priorität: 07.05.2013 DE 102013007838
(43) Veröffentlichungstag der Anmeldung: 12.11.2014
(73) Patentinhaber: KATHREIN-Werke KG, 83004 Rosenheim (DE)
(72) Erfinder: Häntsch, Ralf, 83064 Raubling (DE)
(74) Vertreter: Flach, Dieter Rolf Paul

(56) Entgegenhaltungen:
- EP-A1- 1 703 607
- EP-A1- 2 309 605
- EP-A2- 0 952 765
- DE-C1- 4 129 293
- DE-U- 1 942 570
- DE-U1- 29 709 594

## Beschreibung

Die Erfindung betrifft ein hochfrequenzdichtes Gehäuse bzw. eine hochfrequenzdichte Antennendose nach dem Oberbegriff des Anspruchs 1.

In der Kommunikationstechnik, beispielsweise in der Rundfunk- und Fernseh-Übertragungstechnik sowie auf dem Gebiet der Satelliten-Übertragung, kommt der frequenzdichten Schirmung von Geräten, Gehäusen, Boxen, Cassetten oder allgemein der Verbindung von zwei leitenden Wänden eine große Bedeutung zu. Es soll verhindert werden, dass hochfrequente Strahlung aus dem zu schirmenden Bereich (Gehäuse) nach außen hin austritt. Das gleiche gilt auch für Trennwände innerhalb eines Gehäuses, wenn durch eine hochfrequenzdichte Wand verhindert werden soll, dass elektromagnetische Strahlung in einen anderen geschützten Bereich innerhalb eines Gehäuses dringt. Ferner soll im Umfeld vorhandene hochfrequente Strahlung abgeschirmt werden, um eine unerwünschte Wechselwirkung mit der innerhalb der geschirmten Wände oder des geschirmten Gehäuses untergebrachten Elektronik zu vermeiden.

Ein frequenzdichtes und insbesondere hochfrequenzdichtes Gehäuse wird häufig nicht allgemein nur für elektronische Schaltung benötigt, sondern beispielsweise auch für den speziellen Anwendungsfall einer Antennendose oder z.B. einer Multimedia-Dose gemäß dem heutigen Standard.

Sogenannte Antennendosen sind hinlänglich bekannt. In den meisten Fällen werden sie als Unterputzdosen eingesetzt. Sie weisen eine Einrichtung zum Anschluss zumindest eines Eingangskabels und gegebenenfalls zumindest eines Ausgangskabels auf, in der Regel in der Form eines Koaxialkabels. Entsprechende Antennendosen können als Durchgangs- oder Enddosen geschaltet werden. Über eine in der Multimedia-Dose vorgesehene Koppeleinrichtung können dann die betreffenden Signale ausgekoppelt werden, wenn an der betreffenden Multimedia-Dose ein oder mehrere Teilnehmergeräte beispielsweise zum Empfang von Fernsehprogrammen oder zum Empfang von Rundfunkprogrammen etc. angeschlossen werden sollen.

Auch hier wachsen die Ansprüche an eine hochfrequenzdichte Ausgestaltung einer derartigen Antennen- oder Multimedia-Dose.

Häufigste Ursache von elektromagnetischen Streustrahlen ist die mangelnde Ausführung der Verbindung von Gehäusen und Deckelteilen. Kleine Spalten, die wie Schlitzantennen wirken, können die Schirmdämpfung erheblich verringern. Diese Spalten entstehen durch schlechte Kontakte, Toleranzen oder durch Unregelmäßigkeiten bzw. Unebenheiten der Gehäuse oder Deckeloberflächen.

Von daher weisen Schraub- oder Nietverbindungen auch große Nachteile auf, wenn diese Technik zur Verwirklichung einer hochfrequenzdichten Schirmung eingesetzt werden soll.

Zum Ausgleich von Unregelmäßigkeiten beispielsweise zwischen einem Deckel und einer Gehäuseoberfläche und zur Erzielung einer ausreichenden Schirmung sind bereits die unterschiedlichsten einzufügenden Dichtungselemente oder Kontaktstreifen verwendet worden.

Ein Kontaktstreifen ist beispielsweise aus der DE 198 18 285 C2 als bekannt zu entnehmen.

Eine hochfrequenzdichte Schirmung mit einer spezifischen leicht vorstehenden Prägung zwischen den Befestigungsstellen an einem Deckel und einer vom Deckel übergreifenden Gehäusewand ist beispielsweise aus der EP 1 100 301 B1 als bekannt zu entnehmen.

Eine hochfrequenz-dichte Abdeckung für einen Gehäuserahmen ist ferner aus der DE 43 40 198 C2 bekannt. Die in diesem Zusammenhang verwendete Abdeckung ist an ihrem Umlaufrand mit quer zum Umlaufrand vorstehenden Kontaktzungen versehen, die durch Schlitze voneinander getrennt sind. Im Bereich der zu schirmenden Öffnungen des Gehäuses sind längs der die Öffnung begrenzenden Wandabschnitte im Abstand zueinander sitzende und in den Öffnungsbereich vorstehende Rippen oder Stege vorgesehen. Dies hat zur Folge, dass die Kontaktzungen der Abdeckung im montierten Zustand entgegengesetzt zur Einsteckrichtung konkav durchgebogen sind. Dadurch soll eine hochfrequenz-dichte Schirmung erreicht werden.

Neben lösbaren Verbindungen, beispielsweise unter Verwendung vorstehend genannter Kontaktstreifen oder anderer HF-Dichtschnüre, gibt es auch feste Verbindungen, die durch Verlöten, Verpressen, Verstemmen und Bördeln oder unter Verwendung von leitenden Klebern hergestellt werden können, wobei ein wesentlicher Nachteil darin besteht, dass die Verbindungen nachträglich nicht mehr oder nur höchst schwer wieder gelöst werden können.

Eine hochfrequenzdichte Abdeckung oder Verbindung ist aus der DE 43 40 108 C2 bekannt geworden. Mit einer derartigen hochfrequenzdichten Verbindung kann beispielsweise ein hochfrequenzdichtes Gehäuse hergestellt werden. Dazu weist die flächige Abdeckung an ihrem Umlaufrand quer zu diesem verlaufende Kontaktzungen auf, die durch Schlitze voneinander getrennt sind. Im Bereich der zu schirmenden Öffnung eines Gehäuses oder Gehäuserahmens sind längs der die Öffnung begrenzenden Wandabschnitte des Gehäuserahmens im Abstand zueinander sitzende und in den Öffnungsbereich vorstehende Rippen oder Stege vorgesehen. Die Schlitze in der erwähnten Abdeckung sind in ihrer Breite auf den Abstand zwischen zwei benachbarter Rippen oder Stege so abgestimmt, dass sie in montiertem Zustand zwischen den Kontaktzungen und den Rippen oder Stegen parallel zum Umlaufrand wirksam sind, da die Kontaktzungen in montiertem Zustand entgegengesetzt zur Einsteckrichtung konkav durchgebogen sind.

Allerdings hat sich in der Praxis gezeigt, dass all die geschilderten hochfrequenzdichten Gehäuse letztlich nicht so frequenzdicht sind, wie dies für viele Anwendungsfälle gefordert wird.

Von daher ist bereits vorgeschlagen worden, im Falle eines frequenzdichten Gehäuses eine erste haubenförmige Abdeckung vorzusehen, die beispielsweise aus einem Blech gestanzt ist, welches einen zentralen Abdeckungsbereich aufweist, der von der Formgebung her in Draufsicht der freien Öffnung des abzudichtenden Gehäuses entspricht. Die Haube weist dazu an den umlaufenden Begrenzungskanten abgewinkelte lappen- oder zungenförmige Überstände auf. Dazu wird die Abdeckhaube aus einem flachen Blech gestanzt, mit ihrem zentralen Abdeckungsbereich und den dann lappen- oder zungenförmig überstehenden Blechabschnitten, die dann entsprechend durch Kanten umgelegt werden und mehr oder weniger senkrecht zur Ebene des Abdeckungsbereiches in einer Richtung vorstehen. Mit anderen Worten werden also die jeweils gegenüberliegenden lappen- oder zungenförmigen Überstände an entsprechenden Linien so gekantet, dass eine so gebildete Haube in Umlaufrichtung versetzt zueinander liegende zungenförmige Abschnitte aufweist (bei vier Seiten also vier zungenförmige Abschnitte), die in ein entsprechendes offenes Gehäuse eingesteckt werden können, so dass die an beispielsweise vier umlaufenden Seiten ausgebildeten zungenförmigen Abschnitte wie Federn an der Innenwandung eines metallischen Gehäuses anliegen und der zentrale Abdeckungsbereich der so durch Stanzen und Kanten gebildeten Abdeckhaube die freie Öffnung des Gehäuses verschließt.

Auf das so abgedeckte und an sich schon in einer ersten Stufe geschirmte Gehäuse wird dann eine plattenförmige Abdeckung zusätzlich aufgesetzt, wobei diese plattenförmige Abdeckung in Draufsicht ebenfalls wieder eine Außenkontur und eine Dimensionierung derart aufweist, dass diese plattenförmige Abdeckung in den in Draufsicht offenen Raum des zu schirmenden Gehäuses oberhalb der schon eingesetzten Abdeckhaube von oben her eingesetzt werden kann. An den umlaufenden Wänden des Gehäuses sind bevorzugt in Vertikalrichtung verlaufende und nach innen vorstehende Rippen oder Zungen in einem bestimmten seitlichen Abstandsmaß vorgesehen, die sich dann zusätzlich in die umlaufende Metallkante der plattenförmigen Abdeckung einkerben können, wie dies an sich für einfach geschirmte Gehäuse auch schon bekannt ist. Durch diese doppelte Schirmung soll das Schirmungsergebnis insgesamt verbessert werden.

Eine geschirmte Multimedia-Dose ist beispielsweise aus der DE 10 2011 113 088 A1 bekannt geworden. Das Gehäuse der Multimedia-Dose umfasst eine Gehäuseöffnung, welche durch umlaufende Seitenwände begrenzt ist. Ferner ist ein Schirmungsdeckel vorgesehen, der zur Schirmung der Gehäuseöffnung auf die Gehäuseöffnung aufgesetzt wird und das schirmende Gehäuse elektrisch kontaktiert.

Eine Antennensteckdose ist zudem auch aus der DE 83 21 597.2 U1 bekannt geworden. Die Antennendose kann dabei ebenfalls auf das Gehäuse der Antennendose aufgesetzt werden. Innerhalb des Antennengehäuses wird dabei noch eine Printplatte angeordnet. Der auf das Steckdosengehäuse aufsetzbare kappenförmige Deckel umfasst neben der Deckelplatte einen umlaufenden Randabschnitt, der auf das Steckdosengehäuse aufgesteckt werden kann und dieses umgreift und dadurch schirmen soll.

Ein gattungsbildendes hochfrequenzdichtes Gehäuse ist aus der DE 19 42 570 U bekannt geworden. Die Vorveröffentlichung beschreibt ein allseits geschlossenes und nach oben hin offenes, elektrisch leitfähiges Gehäuse mit mehreren Kammern. Auf den oberen Stirnseiten der umlaufenden Wände des Gehäuses sowie der Kammerwände liegt eine Gummiplatte auf, die mit einer versilberten Kupferfolie umgeben ist. Dadurch soll das Gehäuseinnere allseits geschirmt sein.

Überdeckt wird diese mit einer leitenden Folie beschichtete Gummiplatte von einem Gehäusedeckel 16, der mit einem umlaufenden Rand versehen ist. Dieser Gehäusedeckel mit umlaufenden Rand übergreift die mit der Kupferfolie umgebene Gummiplatte und überdeckt in einer Teilhöhe nach oben hin offene Gehäusewände.

Um die gewünschte Hochfrequenzdichtigkeit herzustellen ist ferner noch eine alles übergreifende Biegeklammer 1 vorgesehen, die an der Gehäuseaußenseite verankert ist und unter Vorspannung auf die Oberseite des Gehäusedeckels drückt. Hierüber wird die Anpresskraft der Feder über den Gehäusedeckel auf die mit der Kupferfolie beschichtete Gummiplatte weitergegeben und dadurch diese mit der Kupferfolie beschichtete Gummiplatte auf die Stirnseiten der Gehäusewände aufgedrückt.

Aus der EP 2 309 605 A1 ist eine Steckdose für die Kommunikationsnetze als bekannt zu entnehmen, deren rückwärtige offene Seite des Gehäusekörpers durch einen Verschlussdeckel verschlossen wird, dessen umlaufende Flanschwände mit Stegen versehen sind, die an der Innenseite des Gehäuses der Steckdose anliegen. Allein hierdurch soll die schirmende Wirkung bewirkt werden.

Die aus der DE 41 29 293 A1 bekannte Antennen-Steckdose beschreibt lediglich, dass das Gehäuse durch eine rückwärtige Bodenplatte verschlossen wird, die in einer umlaufenden Ringschulter an den Gehäusewänden ein- bzw. aufgesetzt ist.

Vor diesem Hintergrund ist es Aufgabe der vorliegenden Erfindung ein frequenzdichtes und insbesondere hochfrequenzdichtes Gehäuse insbesondere in Form einer Antennen- oder Multimedia-Dose zu schaffen. Dabei soll bei einem einfachen Aufbau eine verbesserte Schirmwirkung als bei vergleichbaren, nach dem Stand der Technik bekannten Lösungen ermöglicht werden.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Es muss als überaus überraschend bezeichnet werden, dass mit vergleichsweise einfachen Mitteln nochmals eine deutlich verbesserte Schirmung an metallischen Gehäusen oder Gehäusen mit einem metallischen Überzug geschaffen werden kann.

Dabei bietet die Erfindung auch den Vorteil, dass die verbesserte frequenzdichte und insbesondere hochfrequenzdichte Schirmung bei unterschiedlichsten Gehäusen realisierbar ist, also auch bei Gehäusen, die keine boxen- oder quaderförmige Grundstruktur, sondern beispielsweise in Draufsicht eine n-polygonale Struktur mit z.B. mehr als vier Ecken aufweisen. Die Erfindung ist ebenso bei Gehäusen einsetzbar, die beispielsweise eine Struktur mit bogenförmigen Wänden oder eine Mischstruktur mit teilweise bogenförmigen und geraden Wandabschnitten aufweisen.

Die erfindungsgemäße Lösung zeichnet sich vor allem dadurch aus, dass nunmehr als erste Schirmungsmaßnahme dem zu schirmenden Gehäuseinnenraum zugewandt liegend im Bereich der Öffnung eines Gehäuses ein Deckel, insbesondere ein plattenförmiger Deckel aufgesetzt wird, der an seinem Umlaufrand unter Anwendung herkömmlicher Schirmungsmaßnahmen mit der Gehäuseinnenwand des zu schirmenden Gehäuses verbunden ist und damit zur Schirmung beiträgt.

Ferner schlägt die Erfindung dann vor, dass als zweite Schirmungsmaßnahme eine Schirmungshaube verwendet wird, die auf das zu schirmende Gehäuse aufgesetzt wird und dabei den ersten, vorzugsweise plattenförmigen Schirmungsdeckel mit überdeckt. Entscheidungserheblich ist dabei, dass die entsprechende Haube einen umlaufenden Flansch aufweist, der die Außenseite des zu schirmenden Gehäuses in einer Teilhöhe mit überdeckt.

Dabei ist die Schirmungshaube mit ihrem an der Außenwandung des schirmenden Gehäuses anliegenden Haubenrand oder Haubenflansch umlaufend ausgestaltet, so dass mit anderen Worten der umlaufende Haubenflansch oder Haubenrand keine Unterbrechungen oder Schlitze aufweist.

Die Erfindung schlägt dabei ferner vor, dass der Schirmungsdeckel einen Deckelrand aufweist, zwischen dem und der Innenseiten der Seitenwände eine galvanische Kontaktierung ausgebildet ist. Diese besteht zumindest in Form von galvanischen Kontaktierungsstellen, die in Umfangsrichtung des Schirmungsdeckels 11 versetzt zueinander vorgesehen sind.

Schließlich ist im Rahmen der Erfindung ebenfalls vorgesehen, dass die Schirmungshaube in einer bestimmten Weise dimensioniert ist.

Die Dimensionierung kann dabei derart erfolgen, dass die Seitenwände der Schirmungshaube auf die Seitenwände des schirmenden Gehäuses in montiertem Zustand eine Kraft zur Erhöhung der Kontaktkraft zwischen dem Schirmungsdeckel und den Gehäusewänden ausüben. Alternativ und ergänzend ist ebenso möglich, dass die Schirmungshaube so dimensioniert ist, dass sie einer durch den Schirmungsdeckel verursachten Ausbauchung der Seitenwände des Schirmungsgehäuses nach außen hin zumindest teilweise entgegenwirkt oder diese Seitenwände zurückverformt.

In einer bevorzugten Ausführungsform ist dabei die Außenwandung des Gehäuses im Bereich des aufzusetzenden Haubenrandes und/oder die damit zusammenwirkende Innenseite des Haubenrandes oder des Haubenflansches in Aufsetz- oder Steckrichtung leicht konisch erweitert ausgestaltet. Möglich ist ebenso, dass hier in Aufsteckrichtung sich leicht nach außen konisch erweiternde Stege oder Rippen ausgebildet sind. Dies eröffnet die Möglichkeit, dass die Schirmungshaube problemlos auf die Öffnung des zu schirmenden Gehäuses aufgesetzt werden kann, da die Innenkontur und damit die lichte Aufstecköffnung der Schirmungshaube zumindest geringfügig größer ist als die entsprechende Kontur des zu schirmenden Gehäuses. Zudem wird dadurch jedoch auch sichergestellt, dass beim weiteren Aufstecken der Haube dann durch die leicht konische Ausgestaltung der wechselwirkenden Anlageflächen zwischen Innenseite des umlaufenden Randes der Schirmungshaube bzw. des Außenrandes des zu schirmenden Gehäuses dieser lichte Abstand zwischen beiden Teilen langsam überwunden wird und die Haube unter Erzeugung eines zunehmend stärker wirkenden Presssitzes auf das Gehäuses aufgesetzt wird.

Dadurch wird nicht nur eine verbesserte elektrische Kontaktwirkung und damit Schirmung erzielt, sondern es wird vor allem sichergestellt, dass die Wandungen des zu schirmenden Gehäuses durch den zuvor aufgesetzten Schirmungsdeckel nicht ausbauchen kann (wodurch die Schirmwirkung verringert werden würde), sondern sogar im Falle einer leichten Ausbauchung der Gehäusewandung dann diese Ausbauchung wieder zurückgeführt wird, nämlich durch die aufgesetzte Schirmungshaube.

Schließlich hat sich auch gezeigt, dass die Schirmwirkung auch dadurch verbessert wird, dass die Schirmungshaube den umlaufenden Rand und damit die Kontaktstellen zwischen dem Schirmungsdeckel und der Gehäusewandung des zu schirmenden Gehäuses in einem großen Bereich überdeckt und nicht wie im Stand der Technik unterhalb des flachen, plattenförmigen Schirmungsdeckels im Gehäuse angeordnet ist.

Weitere Vorteile, Einzelheiten und Merkmale der Erfindung ergeben sich aus den anhand von Zeichnungen näher dargestellten Ausführungsbeispielen. Dabei zeigen im Einzelnen:
- Figur 1:: ein zu schirmendes Gehäuse bei abgenommenen Deckel und freier Sicht in den Gehäuseinnenraum;
- Figur 1a:: ein vergrößerter Detailausschnitt des Bereiches Z in Figur 1;
- Figur 2a:: eine räumliche Darstellung eines Schirmungsdeckels;
- Figur 2b:: eine Detaildarstellung des in Figur 2a wiedergegebenen Schirmungsdeckels mit an dem Umfangsrand des Schirmungsdeckels ausgebildeten der Kontaktierung mit dem schirmenden Gehäuse dienenden Zähnen, Flanken oder dergleichen;
- Figur 3a:: eine räumliche Darstellung des in Figur 1 dargestellten zu schirmenden Gehäuses bei aufgesetztem Schirmungsdeckel;
- Figur 3b:: eine räumliche Darstellung einer Schirmungshaube, und zwar auf die Innenseite der Schirmungshaube;
- Figur 4:: eine entsprechende Darstellung zu Figur 3, jedoch bei zusätzlich aufgesetzter Schirmungshaube;
- Figur 4a:: eine Querschnittsdarstellung durch eine Seitenwand des zu schirmenden Gehäuses, wobei der Schnitt durch die Seitenwand in der Nähe des Eckbereiches des zu schirmenden Gehäuses gelegt ist;
- Figur 4b:: eine auszugsweise Draufsicht auf eine Seitenwand des zu schirmenden Gehäuses;
- Figur 4c:: eine axiale Querschnittsdarstellung durch eine Schirmungshaube, wobei der Schnitt benachbart zum Eckbereich der Schirmungshaube gelegt ist;
- Figur 5:: eine räumliche Darstellung einer Antenne- oder Multimedia-Dose bei angeschlossenen Koaxialleitungen;
- Figur 6:: eine Draufsicht auf die in Figur 5 gezeigte Multimedia-Dose;
- Figur 7:: eine teilweise Unteransicht der in Figur 5 und 6 wiedergegebenen Multimedia-Dose bei abgenommenen Schirmungsdeckel und abgenommener Schirmungshaube;
- Figur 7a:: eine vergrößerte Detaildarstellung des in Figur 7 umrissenen Bereiches Z;
- Figur 8:: eine räumliche Darstellung eines Schirmungsdeckels zur Schirmung der Antennen- oder Multimedia-Dose;
- Figur 9:: eine Darstellung der Multimedia-Dose ähnlich zu Figur 7 bei angeschlossenen Koaxialkabeln und aufgesetztem Schirmungsdeckel;
- Figur 10:: eine entsprechende räumliche Darstellung einer Schirmungshaube zur zusätzlichen Schirmung der Antennen- oder Multimedia-Dose, und zwar unter Freigabe der Innenansicht der Schirmungshaube;
- Figur 11:: eine entsprechende Darstellung zu Figur 9 bei zusätzlich aufgesetzter Schirmungshaube;
- Figur 12a:: eine Axialschnittdarstellung durch die mit dem Schirmungsdeckel und der Schirmungshaube verschlossenen, geschirmten Antennen- und Multimedia-Dose;
- Figur 12b:: ein vergrößerte Detaildarstellung des Teilbereiches Z in Figur 12a; und
- Figur 13:: eine zu Figur 7 abgewandelte Ausführungsform, bei der die Auflauf- und Kontaktflächen an einer Seitenwand des schirmenden Gehäuses nicht durch einen insgesamt leicht schräg oder keilförmig verlaufenden Gehäusewandabschnitt, sondern durch stegförmige Ausschnitte gebildet sind.

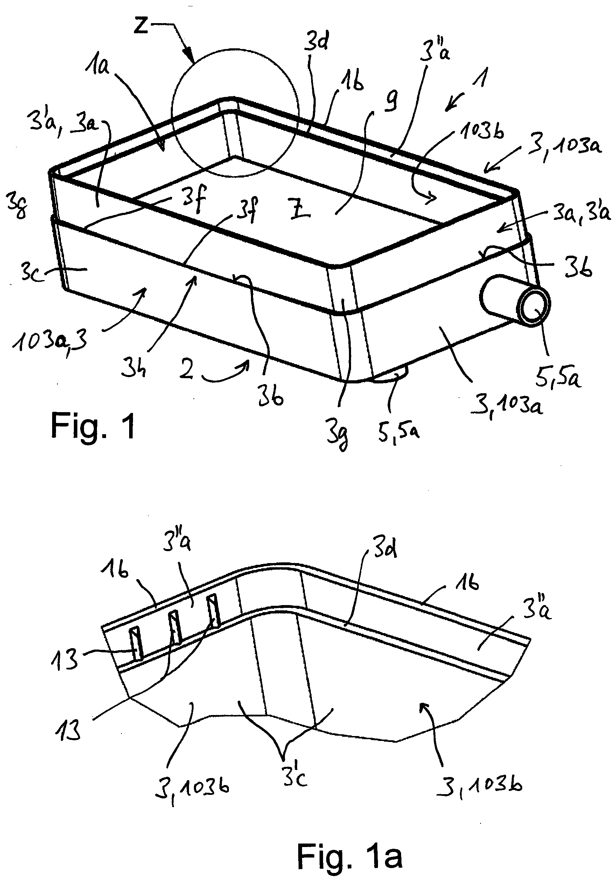

Zunächst wird auf die Figuren 1 und 1a Bezug genommen, in denen eine räumliche Darstellung eines zu schirmenden Gehäuses 1 bzw. ein Ausschnitt Z davon in Figur 1a dargestellt ist, welches boxenförmig gebildet ist und einen Boden 2 sowie vier umlaufende Seitenwände 3 aufweist. Dieses schirmende Gehäuse mit seinem Boden und Seitenwänden kann aus Metall oder einer Metalllegierung gebildet sein, damit der Boden und die Seitenwände frequenzdicht und insbesondere hochfrequenzdicht ausgestaltet sind. Ebenso ist es möglich, dass beispielsweise das Gehäuse aus Kunststoff gebildet ist und innen und/oder außen mit einer metallisierenden Oberfläche zur Erzielung einer schirmenden Wirkung versehen ist.

Zudem kann das Gehäuse mit einem oder mehreren Anschlussstellen 5, sogenannten Anwenderschnittstellen 5a, ausgestattet sein, worüber Anschlusskabel eine Verbindung mit der im Inneren des schirmenden Gehäuses 1 üblicherweise vorgesehenen Elektronik herstellen.

In Figur 1 ist der zu schirmende Innenraum 7 freiliegend dargestellt, wobei die im Innenraum 7 parallel zu dem unten liegenden Boden 2 im Abstand dazu eingebaute Leiterplatte 9 sichtbar ist, allerdings ohne die darauf befindliche Elektronik mit den entsprechenden HF-Komponenten, Filtereinrichtungen, Verstärker, Signalverarbeitungseinheiten, Mikroprozessoren, Widerständen, Filter etc..

Im gezeigten Ausführungsbeispiel sind die umlaufenden Seitenwände 3 auf deren Außenseiten 103a des Gehäuses 1 mit einem umlaufenden äußeren Kontaktabschnitt 3a ausgestattet, auf welchem eine nachfolgend erläuterte Schirmungshaube aufgesteckt wird. Die maximale Aufstecktiefe wird in diesem Ausführungsbeispiel durch einen umlaufenden äußeren Stufenansatz 3b begrenzt, der von der oben liegenden Gehäuseöffnung 1a in Höhe des umlaufenden Gehäuserandes 1b bis zum Stufenansatz 3b reicht. Der vom Gehäuserand 1b bis zum Stufenansatz 3b gebildete äußere Kontaktabschnitt 3a mit einer Kontakthöhe 3e der jeweiligen Gehäusewand 3 ist dabei im gezeigten Ausführungsbeispiel mit dünnerer Wandstärke und/oder mit in Richtung Innenraum 7 des Gehäuses 3 versetzt liegender Kontaktoberfläche 3'a ausgebildet, und zwar gegenüber der verbleibenden äußeren Oberfläche 3c des den Boden näherliegenden verbleibenden Wandabschnittes der Seitenwand 3.

Wie aus den Figuren 1 und 1a auch zu ersehen ist, ist auch im Innenraum 7 auf der Innenseite 103b der Seitenwände 3 vom oberen Randbereich 1b ausgehend in Richtung Boden 2 in einer Teilhöhe die Seitenwand 3 mit verringerter Wandstärke ausgebildet. Dadurch wird ein innenliegender Stufenabsatz 3d gebildet. Mit anderen Worten ist die innen liegende Wandoberfläche 3"a zwischen dem innen liegenden Stufenabsatz 3d und des oben liegenden Gehäuserandes 1b nach außen liegend versetzt, also gegenüber der verbleibenden inneren Wandoberfläche 3'c zwischen dem inneren Stufenabsatz 3d und dem Boden 2.

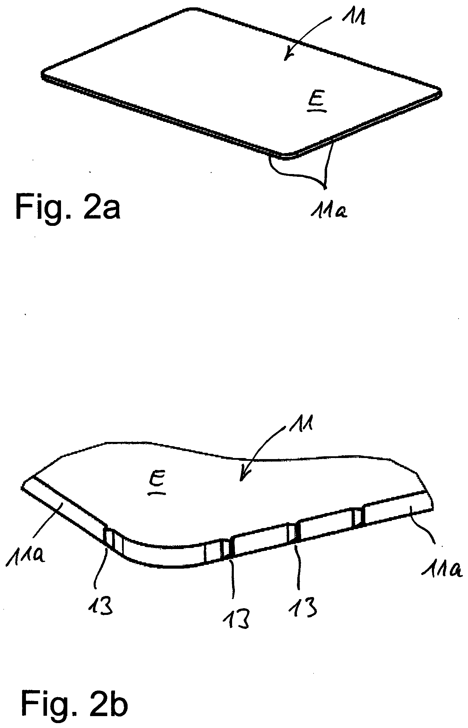

Anhand von Figur 2a ist nunmehr ein Schirmungsdeckel 11 gezeigt, der im wiedergegebenen Ausführungsbeispiel plattenförmig gestaltet ist. Seine Dimensionierung in Längs- und Querrichtung und seine Formgebung in Draufsicht entsprechen der lichten Öffnungsweite der Gehäuseöffnung 1a, so dass der so gebildete Schirmungsdeckel 11 über die oben liegende Gehäuseöffnung 1a im Bereich des stirnseitigen Gehäuserandes 1b auf das zu schirmende Gehäuse 1 aufgesetzt und bis zu dem innenliegenden Stufenansatz 3d aufgesetzt werden kann. Dabei können die inneren Oberflächen 3"a von dem Gehäuserand 1b bis zu dem inneren Stufenabsatz 3d in Richtung Boden 2 leicht konisch aufeinander zulaufen, wobei der Schirmungsdeckel 11 bevorzugt zumindest in Höhe des inneren Stufenabsatzes 3d fest sitzen sollte, indem sein umlaufender Deckelrand 11a die innere Oberfläche 3"a der Seitenwände 3 berührt.

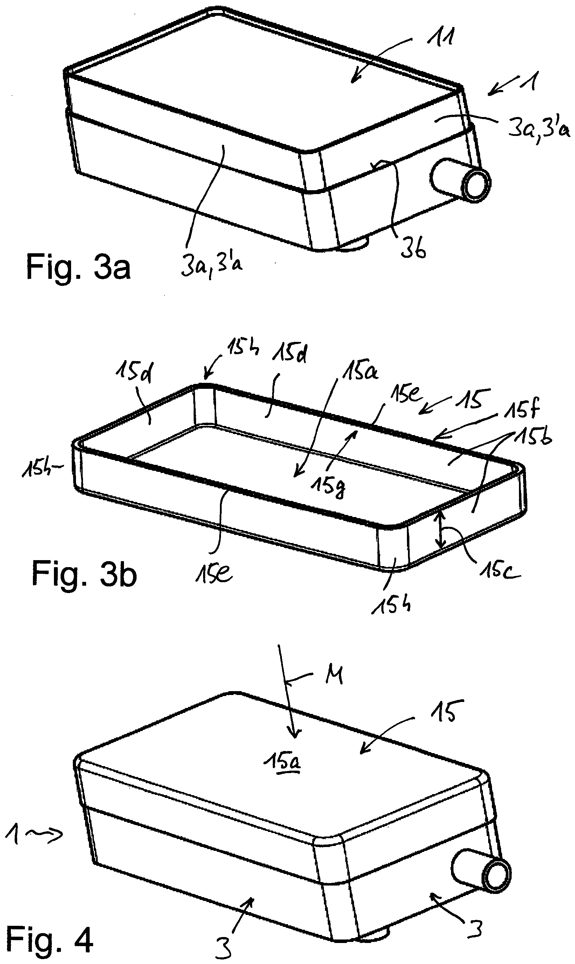

Position und Lage des auf- bzw. eingesetzten Schirmungsdeckels 11 ist in der räumlichen Darstellung gemäß Figur 3a wiedergegeben. Durch diesen Schirmungsdeckel 11 wird die Gehäuseöffnung 1a als erstes verschlossen.

Um auch hier schon eine möglichst gute HF-Schirmung zu erzielen, können übliche Maßnahmen vorgesehen sein. Anhand von Figur 2b ist dabei ausschnittsweise gezeigt, dass an dem umlaufenden Rand 11a des Schirmungsdeckels 11 in Steckrichtung, also im gezeigten Ausführungsbeispiel senkrecht zur Ebene E des Schirmungsdeckels 11 verlaufend und in Umfangsrichtung versetzt zueinander in geringen Abständen liegend Zähne, Rippen oder Stege 13 ausgebildet sein können, die sich beim Aufsetzen des Schirmungsdeckels 11 an der oben liegenden Innenwand 3e oberhalb des inneren Stufenabsatzes 3d einkerben und hier zu einer galvanischen Kontaktierung beitragen, da auch der Schirmungsdeckel 11 bevorzugt aus Metall besteht und nicht nur aus einem dielektrischen Körper, der mit einer metallischen Schicht überzogen ist.

Wie anhand von Figur 1a teilweise dargestellt ist, können umgekehrt auch an der Innenwandung 3"a bevorzugt in Einsteckrichtung, d. h. in Vertikalrichtung, d.h. in Montagerichtung 11, oder in senkrechter Ausrichtung zur Ebene E des Schirmungsdeckels 11 Zähne, Rippen oder Stege 13 ausgebildet sein, die in Umfangsrichtung umlaufend an der oberen Innenwand 3"a des Gehäuses ausgebildet sind.

Bei entsprechender Dimensionierung des Schirmungsdeckels 11 in Längs- und Querrichtung kann dadurch gewährleistet werden, dass der umlaufende Rand 11a sich in diese nunmehr an der inneren Oberfläche, also der Innenwandung 3"a des Gehäuses 1 ausgebildeten Zähne, Rippen, Stege 13 einkerbt und somit zu den gleichen, gewünschten galvanischen Kontaktierung und damit elektrischen Verbindung zwischen Schirmungsdeckel 11 und Gehäuse 1 beiträgt. Alle geeigneten Maßnahmen kommen hier in Betracht, beispielsweise auch die Ausbildung von elastischen Zungen an der Innenwandseite 3e des Gehäuses oder des Schirmungsdeckels etc., so dass der Schirmungsdeckel dann auch haubenähnlich gestaltet wäre.

Mit anderen Worten wird also wie erläutert der Schirmungsdeckel 11 in die Gehäuseöffnung 1a eingesetzt bzw. eingepresst, wobei die entsprechenden Kontaktpunkte zwischen dem Schirmungsdeckel und dem Gehäuse 1 durch Verwendung von Federelementen an dem Schirmungsdeckel 11 und/oder an der Innenwandseite des Gehäuses 1 oder durch Kontaktiereinrichtungen auf den Wandinnenseiten der Seitenwänden und/oder am umlaufenden Deckelrand 11a realisiert werden können.

Es besteht ebenso die Möglichkeit, den Deckel geringfügig kleiner als die entsprechende Gehäuseöffnung auszuführen und die für die Schirmung notwendigen Kontaktbereiche durch partielles oder umlaufendes Verbördeln bzw. Umlegen des Gehäuserandes zu erzwingen. Dabei wird der Deckel zusätzlich auf den Stufenabsatz 3d des Gehäuses gedrückt, wodurch die Schirmung verbessert wird.

Bei allen der geschilderten Maßnahmen entstehen dadurch die gewünschten Kontaktpunkte durch Verformung des Gehäuses oder Verformungen am außen liegenden Umfangsrand des Schirmungsdeckels 11.

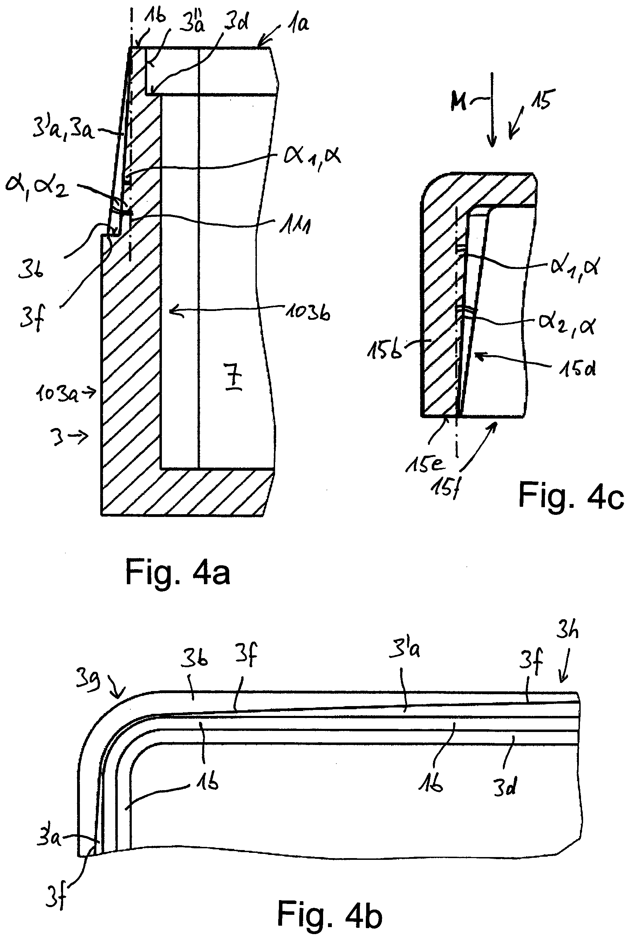

Nachfolgend wird die anhand von Figur 3b gezeigte Schirmungshaube 15 auf das zu schirmende Gehäuse 1 aufgesetzt, wobei die Schirmungshaube 15 dabei nicht nur die Gehäuseöffnung 1a sondern auch den bereits dort zuvor eingesetzten Schirmungsdeckel 11 übergreift und überdeckt (Figur 4).

Die Schirmungshaube 15 weist dabei gemäß Figur 3b einen zentralen Haubenabschnitt 15a auf, der in Draufsicht auf die gesamte Anordnung die Gehäuseöffnung 1a und damit das darunter befindliche Gehäuse 1 überdeckt. Dieser zentrale Haubenabschnitt 15a ist mit einem umlaufenden Wand-, Rand- oder Flanschabschnitt 15b versehen, der geschlossen umlaufend ausgebildet ist und sich über eine Haubenhöhe 15c von dem eigentlichen Deckelboden, d.h. dem zentralen Haubenabschnitt 15a erhebt. Der so gebildete Deckel, d.h. die Haube 15 ist wie erwähnt dann auf das bereits mit dem Schirmungsdeckel 11 verschlossene Gehäuse 1 aufgesetzt, in dem der erwähnte Wand-, Rand- oder Flanschabschnitt 15b den Kontaktabschnitt 3a auf den Seitenwand-Außenflächen 3'a der Seitenwände 3 übergreift und dabei mit der Kontaktoberfläche 3'a des Kontaktabschnittes 3a des Gehäuses 1 in Kontakt steht.

Um hier eine möglichst gute, schirmende Kontaktwirkung zu erzielen, kann beispielsweise die äußere Kontaktoberfläche 3'a im Steck- und Kontaktbereich der Seitenwände 3 am oben liegenden Gehäuserand 1b und gegebenenfalls noch benachbart dazu in Draufsicht gerade verlaufen, also eben, wobei die außenliegende Kontaktoberfläche 3'a zu dem in Steck- und Montagerichtung M gegenüber dem Gehäuserand 1b tieferliegend Stufenansatz 3b in eine in Draufsicht leicht bauchige, d.h. nach außen leicht konvex vorstehende Kontaktaußenfläche 3'a übergeht (siehe Figur 4a). Dies hat eine positive Wirkung. Denn das Einsetzen des Schirmungsdeckels 11, beispielsweise unter Verwendung von zwischen dem umlaufenden Rand des Schirmungsdeckels 11 und der angrenzenden Innenwand des schirmenden Gehäuses 1 vorgesehenen Zähnen, Rippen oder Stege 13 kann dazu führen, dass die Seitenwände des Gehäuses 1, d.h. vor allem die langen Seitenwände 3 des Gehäuses 1 vor allem in ihrem mittleren Bereich nach außen aufbauchen. Dies hat zur Folge, dass an sich hier die Kontaktwirkung zwischen dem zuvor eingesetzten Rand 11a des Schirmungsdeckels 11 und der Innenwandseite des Gehäuses 1 abnimmt oder hier nicht in ausreichendem Maße die an sich gewünschte Kontaktierung dauerhaft vorhanden ist, um eine ausreichende schirmende Wirkung zu erzielen. Durch die aufgesetzte Haube 15 mit ihrem umlaufenden Wandabschnitt 15b und der entsprechend in Draufsicht leicht konkav geformten außenliegenden Kontaktoberfläche 3'a im Steckbereich des Gehäuses werden die eventuell ausbauchenden Abschnitte der Seitenwände 3 des Schirmgehäuses 1 nach innen herangezogen. Somit trägt die Schirmungshaube 15 nicht nur durch ihre Existenz zur verbesserten Hochfrequenzschirmung bei sondern verstärkt auch die hochfrequenzschirmende Wirkung zwischen dem darunter befindlichen Schirmungsdeckel 11 und der Innenwandung des Gehäuses 1.

Die Schirmungshaube 15 übt auf die Seitenwände 3 des Gehäuses Kräfte aus, wodurch die Kontaktkraft zwischen Deckel 11 und Gehäusewand 3 vergrößert wird und wodurch eine ausgebauchte Seitenwand zumindest teilweise rückverformt wird. Der Deckel 11 versteift gleichzeitig die Gehäuseseitenwände 3 des Gehäuses. Dadurch wird verhindert, dass die Schirmungshaube 15 die Seitenwände 3 nach innen einbeult.

Mit anderen Worten sollten die Kontaktwandabschnitte 3a der Seitenwände 3, d.h. deren außenliegende Kontaktoberflächen 3'a vom oben liegenden Gehäuserand 1b zu dem dazu versetzt liegenden tieferen Stufenansatz 3b leicht divergierend ausgebildet sein, und dabei vor allem im mitterlen Bereich der Seitenwände eventuell sogar etwas stärker divergierend ausgebildet sein. Mit anderen Worten nimmt der schräg verlaufende Neigungswinkel α gegenüber einer zum Boden oder zur Ebene des Bodens 2 bzw. der Ebene E des Schirmungsdeckels 11 senkrecht stehenden Geraden 111, die parallel zur Steck- und Montagerichtung M verläuft (Figur 4a) vom äußeren Eckbereich 3g (α1) zu einem mittleren Seitenwandbereich 3h (α2) der jeweiligen ansonsten mehr oder weniger gerade verlaufenden Seitenwand 3 zu. Dadurch ergibt sich in schematischer Draufsicht auf das schirmende Gehäuse 1 gemäß der Detaildarstellung nach Figur 4b für die Kontaktoberflächen 3'a eine untere Begrenzungslinie 3f, die gegenüber dem Rand 1b des Gehäuses 1 im mittleren Seitenwandbereich 3h weiter vorsteht als im Eckbereich 3g des schirmenden Gehäuses. Ist der obere Einsteckrand 1b gerade verlaufend ausgebildet, ergibt sich dann abweichend von der Geraden eine zumindest leicht bauchige oder konvexe Gestaltung der unteren Abschluss- oder Begrenzungslinie 3f.

Da die Seitenwände 15b der Schirmungshaube 15 in den Eckbereichen relativ steif sind, wird durch die bauchige Form der Seitenwände 3 des Gehäuses eine optimale spaltfreie Anschmiegung der Haubenseitenwände 15b an die Gehäuseseitenwände 3 erzielt, was eine deutliche Verbesserung der Schirmwirkung bewirkt.

Umgekehrt könnten aber auch die der umlaufenden Wand-, Rand- oder Flanschabschnitte 15b der Schirmungshaube 15 entgegengesetzt der Aufsteckrichtung M vom umlaufenden Haubenrand 15e in Höhe des Öffnungsbereiches 15f des Wand-, Rand- oder Flanschabschnittes 15b ausgehend zu dem zentralen Haubenabschnitt 15a leicht konvergierend ausgebildet sein, um den gleichen Effekt zu erzielen (Figur 4c). Dabei könnte die leicht konvergierend verlaufenden Haubeninnenwandflächen 15d der Wand-, Rand- oder Flanschabschnitte 15b zum mittleren Bereich 15g der Wand-, Rand- oder Flanschabschnitte 15b ausgehend von den Eckbereichen 15h entgegengesetzt zur Aufsteckrichtung M zunehmend stärker konvergierend ausgerichtet sein, wie dies in der Detail-Schnittdarstellung (Figur 4c) durch eine Seitenwand 15b der Haube 15 benachbart zum Eckbereich der Haube gezeigt ist.

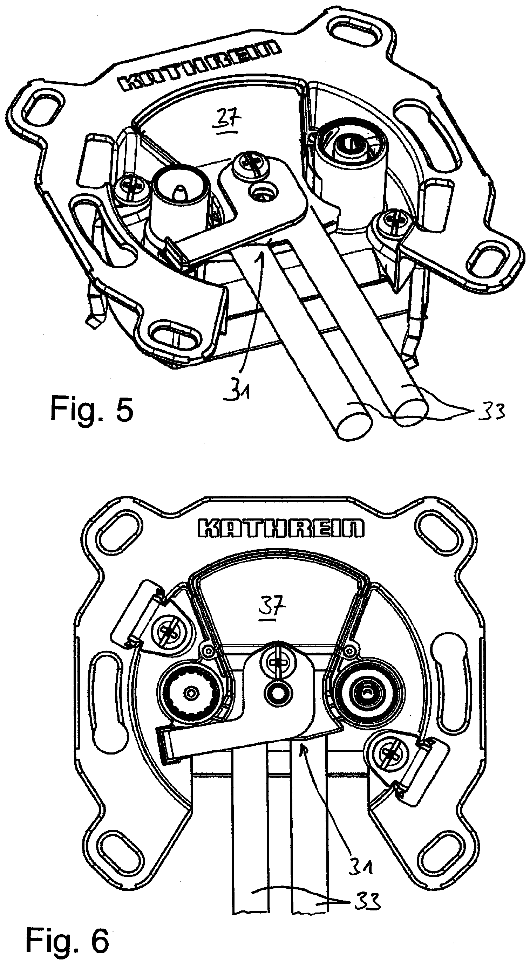

Die erwähnten unterschiedlichen starken Neigungen auf der Innenseite 15d der Wand-, Rand- oder Flanschabschnitte 15b der Schirmungshaube 15 und/oder die entsprechend unterschiedlich stark geneigte Ausbildung der Kontaktoberflächen 3'a am Außenumfang des Gehäuses 1 müssen nicht kontinuierlich ausgebildet sein. Wie in Figur 5a und 5b dargestellt ist, können zumindest auf der Innenseite 15f des Wand-, Rand- oder Flanschabschnittes 15b und/oder an den Kontaktaußenflächen 3'a des Gehäuses 1 stegförmige Erhebungen ausgebildet sein, die in Umlaufrichtung versetzt zueinander liegen, um einen gleichen Effekt zu erzeugen.

Durch diese Gesamtanordnung in Form einer doppelten Schirmung mit innen liegendem Schirmungsdeckel 11 und außen angeordneter, den Schirmungsdeckel 11 und die Gehäusewandung zumindest in einer Teilhöhe in einem Überlappungsbereich übergreifende Schirmungshaube 15 wird die gegenüber bisher allen bekannten Lösungen deutlich verbesserte schirmende Wirkung erzielt.

Diese Anordnung hat den besonderen Vorteil, dass sich beide Schirmungssysteme gegenseitig in ihrer Wirkung unterstützen. Die Schirmungshaube 15 erhöht die Kontaktkräfte zwischen Deckel 11 und Gehäusewänden 3. Andererseits verhindert der Deckel, dass die Haube 11 die Gehäuseseitenwände 3 nach innen verformt.

Die Haubenhöhe 15c des Wand-, Rand- oder Flanschabschnittes 15b der Schirmungshaube 15, die in aufgesetzter und montierter Position die entsprechenden Seitenwände 3 des schirmenden Gehäuses 1 übergreifen, sollte zumindest 2mm, vorzugsweise zumindest 3mm, 4mm, 5mm, 6mm, 7mm, 8mm, 9mm oder zumindest 10mm groß sein. Ansonsten ist eine Obergrenze nicht vorgegeben. Da die schirmende Wirkung allerdings in dieser Größenordnung ausreichend ist, wird die Höhe dieses Wand-, Rand- oder Flanschabschnittes 15b in der Regel kleiner als 20mm, insbesondere kleiner als 17,5mm, 15mm, 12,5mm, 10mm oder 7,5mm sein.

Besonders vorteilhaft ist es, wenn die Überdeckung zwischen Schirmungshaubenwand 15b und Gehäusewand 3 größer als 6mm ist. In diesem Fall wird die Schirmwirkung durch kleine Schlitze nur geringfügig wegen dann auftretender Hohlleiterdämpfung bzw. Kaminwirkung beeinflusst.

Das erläuterte Prinzip eines doppelt geschirmten Gehäuses kann für jedwede Gehäuseform realisiert werden. Dieses erfindungsgemäße Prinzip wird nachfolgend anhand einer Antennen- oder Multimedia-Dose gezeigt und beschrieben.

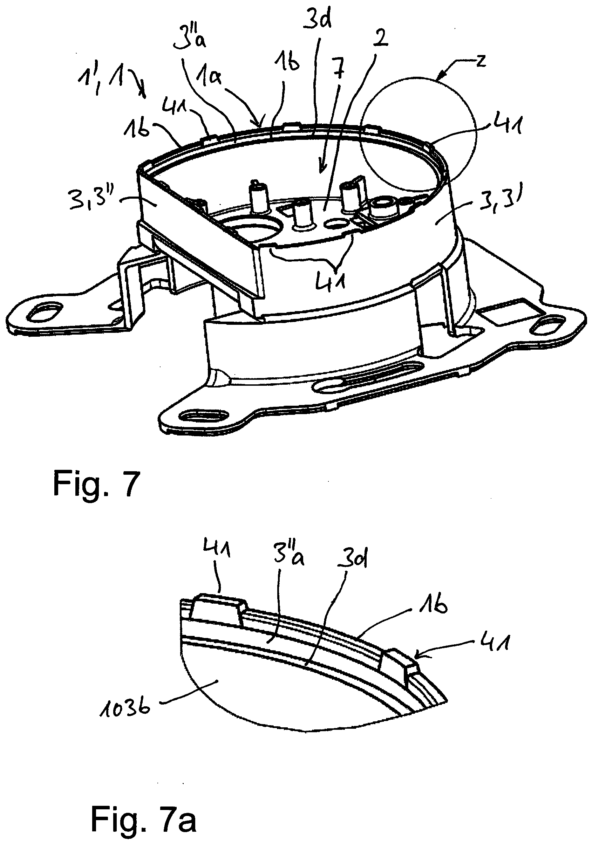

In Figur 5 ist eine übliche Antennen- oder Multimedia-Dose in räumlicher Darstellung, in Figur 6 in Draufsicht und in Figur 7 in einer Unteransicht ohne eingebaute Schirmungsmaßnahmen wiedergegeben. Diese Antennen- oder Multimedia-Dose umfasst einen Kabelanschlussraum 31 in üblicher und bekannter Ausbildung unter Verwendung von ein oder mehreren nicht näher gezeigten Querrippen, die zur galvanischen Kontaktierung mit dem jeweiligen Außenleiter der in Figur 5 und 6 gezeigten beiden koaxialen Anschlusskabeln 33 dient. Die am Kabelende in Axialrichtung über den Außenleiter überstehenden Innenleiter können dann unterhalb einer Abschlussklappe 37 in dort unter der Abschlussklappe 37 vorgesehenen Innenleiteranschlussstellen in der Regel unter Verwendung von Schrauben galvanisch angeschlossen werden. Es wird insoweit auf bekannte Lösungen verwiesen.

Anhand von Figur 7 ist die Unterseite des Gehäuses 1 der Antennen- oder Multimedia-Dose gezeigt, und zwar mit einem Anschlussgehäuse 1, welches in diesem Ausführungsbeispiel auch als Anschlussgehäuse 1' bezeichnet wird. Auch dieses Anschlussgehäuse 1, 1' weist wie bei dem vorausgegangenen Ausführungsbeispiel eine umlaufende Seitenwand 3 auf, wie sie in diesem Ausführungsbeispiel in eine bogenförmig konvex gestaltete Seitenwand 3' und eine mehr oder weniger zumindest näherungsweise gerade verlaufende Seitenwand oder Seitenwandabschnitt 3" umfasst. Auch dadurch wird ein Gehäuseinnenraum umgrenzt, der üblicherweise ebenfalls mit einem schirmenden Boden 2 versehen ist, der mit der Seitenwand 3', 3" in der Regel stoffschlüssig verbunden ist.

Im Inneren 7 des so gebildeten Gehäuses ist dann wieder die übliche Elektronik untergebracht, beispielsweise unter Verankerung einer Leiterplatine mit den darauf sitzenden elektronischen Bauteilen. Dies ist der Einfachheit halber nicht näher dargestellt.

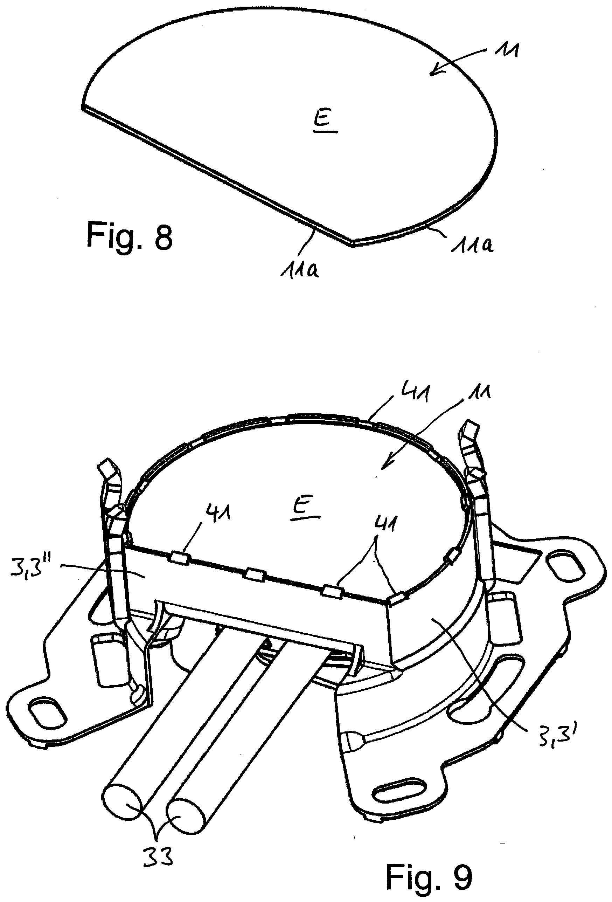

Die Ausbildung der Seitenwandabschnitte 3, 3', 3" ist auch in diesem Ausführungsbeispiel ähnlich zu dem vorausgehenden. Wie zu ersehen ist, weisen die Seitenwände 3, d.h. 3', 3" innenliegend benachbart zur Gehäuseöffnung 1a im Bereich des oben umlaufenden Gehäuserandes 1b einen dazu tiererliegenden umlaufenden inneren Stufenansatz 3d auf, auf welchen wiederum der anhand von Figur 8a gezeigte Schirmungsdeckel 11 aufgesetzt werden kann. Auch in diesem Ausführungsbeispiel weist also der Schirmungsdeckel 11 eine Formgebung auf, die der Formgebung und Kontur der zu schließenden Gehäuseöffnung 1a entspricht. Der Schirmungsdeckel 11 wird auch hier bis zu einem Anschlag auf den innenliegenden Stufenansatz 3d in die Gehäuseöffnung 1a eingeschoben. Zwischen dem umlaufenden Rand 1b des Schirmungsdeckels 11 und der Innenseite der Seitenwände 3, d.h. 3' und 3" können wiederum die anhand des vorausgegangenen Ausführungsbeispiels geschilderten Maßnahmen ausgebildet sein, um hier die galvanischen Kontaktierungsflächen zur Erzielung einer guten Schirmung herzustellen.

Nachdem der in Figur 8 gezeigte gegebenenfalls nur plattenförmig ausgestaltete Gehäusedeckel in der Öffnung 1a des Gehäuses 1 der Antennen- oder Multimedia-Dose eingesetzt ist, können dann zur Verankerung des Gehäusedeckels 11, also des Schirmungsdeckels 11 und auch zur Herstellung einer guten elektrischen Kontaktierung die am Umfangsrand 1b der Seitenwände 3, 3', 3" im Abstand zueinander sitzenden Halte- und Kontaktkrallen der -zungen 41 (Figur 7a) leicht in Richtung Schirmungsdeckel 11 verbogen, gekantet, umgebördelt, allgemein umgelegt werden, bis sich die in Figur 9 wiedergegebene Darstellung ergibt. Dadurch ist der der Schirmung dienende Schirmungsdeckel 11 mechanisch gesichert und elektrisch mit dem Gehäuse 1 und den Gehäusewandungen 3 kontaktiert, wobei die entsprechenden Haltekrallen oder Kontaktzungen 41 sowohl an den kurvigen Seitenwandabschnitten 3' wie an den mehr oder weniger gerade verlaufenden Seitenwandabschnitten 3" entsprechend in Abständen ausgebildet sind.

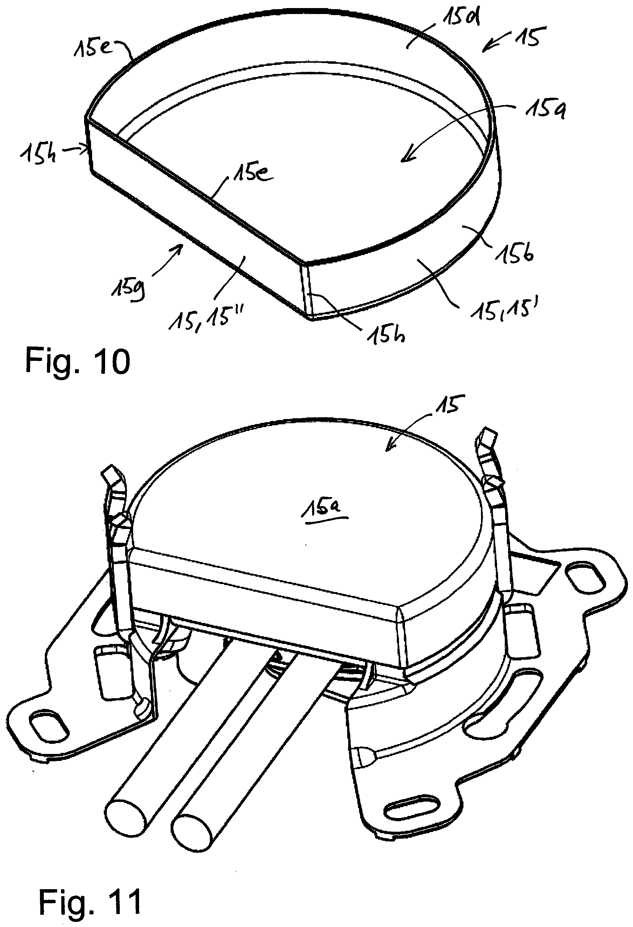

Anschließend wird wiederum die anhand von Figur 10 von der Unterseite her gezeigte Schirmungshaube 15 aufgesetzt. Die Schirmungshaube 15 weist wiederum in Draufsicht eine Kontur oder Formgebung auf, die der Kontur oder Formgebung des Gehäuses 1 entspricht. Von daher ist die Schirmungshaube 15 in diesem Fall ebenfalls mit einem entsprechend runden, hier sogar kreisförmigen und zusätzlich einem gerade verlaufenden Wand-, Rand- oder Flanschabschnitt 15' bzw. 15" ausgestaltet, wobei dieser Wand-, Rand- oder Flanschabschnitt 15 wiederum eine Haubenhöhe 15c aufweist, die bevorzugt in jener Größenordnung liegt, wie dies anhand des Vorausgegangenen Ausführungsbeispiels erläutert wurde.

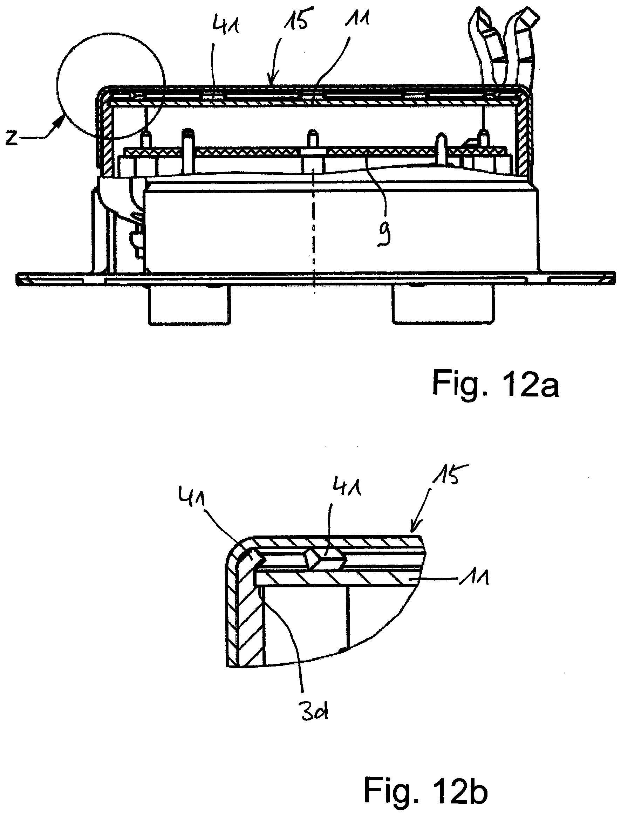

In Figur 11 ist in räumlicher Darstellung die Antennen- oder Multimedia-Dose von der Unterseite bei endgültig aufgesetzter Schirmungshaube wiedergegeben. In Figur 12a ist die erfindungsgemäße Antennen- und Multimedia-Dose bei endgültig aufgesetzter und verankerter Schirmungshaube 15 im Axialschnitt wiedergegeben, wobei in Figur 12b ein Detailausschnitt Z der Darstellung aus Figur 12a vergrößert gezeigt ist. Auch bei diesem Ausführungsbeispiel weisen also die äußeren Kontaktoberflächen 3'a an den äußeren Seitenwänden 3, 3', 3" in Aufsteck- und Montagerichtung M der Schirmungshaube 15 eine zumindest leichte konische Erweiterung auf, auf die unter Erzeugung eines entsprechenden Press- und Passsitzes die Haube 15 bis zu einer endgültigen Aufsteckstellung aufgeschoben werden kann.

An der mehr oder weniger gerade verlaufenden Seitenwand 3" ist die in Einsteck- und Montagerichtung M leicht divergierende äußere Kontaktoberfläche 3'a unterschiedlich stark ausgebildet. Die divergierende Ausrichtung der äußeren Kontaktoberfläche 3'a ist im Eckbereich 3g des schirmenden Gehäuses 1 geringer und im mittleren Bereich einer Seitenwand 3, 3" stärker, so dass sich wieder die in Draufsicht leicht konvexe untere Begrenzungslinie 3f ergibt. Dies führt zur stärkeren Kraftbeaufschlagung beim Aufsetzen der Schirmungshaube, wodurch die gerade verlaufende oder eher gerade verlaufende Seitenwand 3" dann wieder stärker nach innen in Richtung Innenraum 7 kraftbeaufschlagt und gedrückt wird, wodurch ein besserer Kontakt zwischen der Innenseite dieser eher gerade verlaufenden Seitenwand 3" und den zuvor eingesetzten Schirmungsdeckel 11 erzielen lässt, unabhängig davon, welche Kontaktmaßnahmen dort zwischen Schirmungsdeckel oder umlaufenden Deckelrand 11a des Schirmungsdeckel 11 vorgesehen ist.

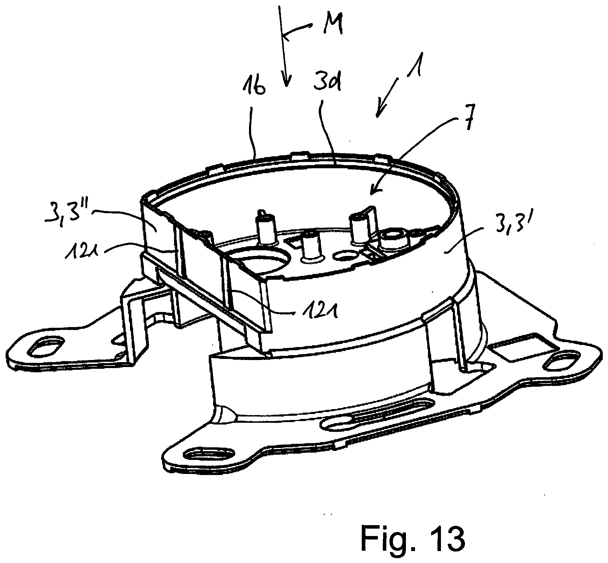

Anhand von Figur 13 ist lediglich in Abweichung zum vorausgegangenen Ausführungsbeispiel gezeigt, ähnlich wie bei dem Ausführungsbeispiel im Fall einer schachtel- oder boxenförmigen Gehäuseanordnung, dass an der geraden oder eher gerade verlaufenden Seitenwand 3, 3" beispielsweise von oben nach unten in Steckrichtung der Haube 15 leicht divergierende oder keilförmige Stege oder Rampen 121 ausgebildet sein können, auf die die Haubeninnenwandflächen 15d auflaufen und die gleiche Kraftbeaufschlagung der Wand 3" in Richtung Innenraum 7 erzeugen. Ebenso könnten vergleichbare keilförmige Erweiterungen auch auf den Haubeninnenwandflächen 15d ausgebildet sein, bei der die Keilflächen im Gegensatz zur Montagerichtung M vom Öffnungsrand 15f zum zentralen Haubenabschnitt 15a leicht konvergierend ausgebildet sind.

Besonders hohe Schirmungswerte erzielt man, wenn ein Teil des aus Deckel 11 und Schirmungshaube 15 bestehenden Schirmungssystems aus einem hochpermeablen Material und das andere Teil aus einem Material mit sehr hoher elektrischer Leitfähigkeit gefertigt wird. Das hochpermeable Material schirmt gegen niederfrequente elektromagnetische Felder sehr gut ab. Bei höheren Frequenzen sind Materialien mit sehr guter elektrischer Leitfähigkeit zur Schirmung besser geeignet. Beispielsweise kann für den Deckel ein Stahlblech und für die Schirmungshaube Aluminium verwendet werden.

Mit dem beschriebenen Gehäuse erreicht man sehr hohe Schirmungswerte, wobei sowohl Deckel 11 als auch Schirmungshaube 15 sehr kostengünstig durch Stanzen sowie Tiefziehen bzw. Prägen herstellbar sind. Für beide Teile sind keine teuren Federmaterialien erforderlich.

## Patentansprüche

1. Hochfrequenzdichtes Gehäuse, insbesondere hochfrequenzdichte Antennen- oder Multimedia-Dose mit folgenden Merkmalen
- es ist ein schirmendes Gehäuse (1) mit einer abzuschirmenden Gehäuseöffnung (1a) vorgesehen,
- das schirmende Gehäuse (1) umfasst einen Boden (2) und umlaufende Seitenwände (3; 3', 3"),
- es ist ein Schirmungsdeckel (11) zur Schirmung der Gehäuseöffnung (1a) vorgesehen, der die Gehäuseöffnung (1a) verschließt,
- es ist ferner eine Schirmungshaube (15) vorgesehen, die neben einem zentralen Haubenabschnitt (15a) quer dazu vorstehende Wand-, Rand- oder Flanschabschnitte (15b) umfasst,
- die Schirmungshaube (15) ist mit ihren Wand-, Rand- oder Flanschabschnitten (15b) auf die Gehäuseöffnung (1a) so aufgesetzt, dass die Wand-, Rand- oder Flanschabschnitte (15b) der Schirmungshaube (15) die Seitenwände (3) des schirmenden Gehäuses (1) auf deren Außenseite (103a) übergreift,
- die die Gehäuseöffnung (1a) übergreifende Schirmungshaube (15) ist mit ihren Haubeninnenwandflächen (15d), die auf der Innenseite der Wand-, Rand- oder Flanschabschnitte (15b) ausgebildet sind, mit äußeren Kontaktoberflächen (3'a) an der Außenseite (103a) der Seitenwände (3, 3', 3") elektrisch kontaktiert,
**gekennzeichnet durch** die folgenden weiteren Merkmale:
- der Schirmungsdeckel (11) ist zur Schirmung der Gehäuseöffnung (1a) in diese eingesetzt,
- der Schirmungsdeckel (11) ist auf der Innenseite des schirmenden Gehäuses (1) mit diesem elektrisch kontaktiert,
- der Schirmungsdeckel (11) weist einen Deckelrand (11a) auf, zwischen dem und der Innenseite (103b) der Seitenwände (3) eine galvanische Kontaktierung besteht, zumindest in Form von in Umfangsrichtung des Schirmungsdeckels (11) versetzt zueinander vorgesehenen galvanischen Kontaktierungsstellen, worüber die galvanische Kontaktierung zwischen dem Schirmungsdeckel (11) und der Innenseite (103b) der Seitenwände (3) erzeugt ist, und
- die Schirmungshaube (15) ist so dimensioniert,
a) dass deren Seitenwände (15b) auf die Seitenwände (3) des schirmenden Gehäuses (1) im montierten Zustand eine Kraft zur Erhöhung der Kontaktkraft zwischen dem Schirmungsdeckel (11) und den Gehäuseinnenwänden (3"a) ausüben, und/oder
b) dass die Schirmungshaube (15) einer **durch** den Schirmungsdeckel (11) verursachten Ausbauchung der Seitenwände (3) des schirmenden Gehäuses (1) nach außen hin zumindest teilweise entgegenwirkt oder diese Seitenwände (3) zurückverformt.

2. Hochfrequenzdichtes Gehäuse nach Anspruch 1, **dadurch gekennzeichnet, dass** an den Innenseiten (103b) der Seitenwände (3) des schirmenden Gehäuses (1) ein innerer Stufenabsatz (3d) ausgebildet ist, auf welchem der Schirmungsdeckel (11) aufsitzt, wobei die galvanische Kontaktierung zwischen dem Schirmungsdeckel (11) und der Innenseite (103b) der Seitenwände (3) über den Stufenabsatz (3d) und/oder die oberhalb des Stufenabsatzes (3d) ausgebildete innere Oberfläche (3"a) besteht.

3. Hochfrequenzdichtes Gehäuse nach Anspruch 1 oder 2, **dadurch gekennzeichnet, dass** an der inneren Oberfläche (3"a) der Seitenwände (3) und/oder am umlaufenden Deckelrand (11a) des Schirmungsdeckels (11) vorzugsweise in Steck- und Montagerichtung (M) des Schirmungsdeckels (11) bezogen auf die Gehäuseöffnung (1a) des schirmenden Gehäuses (1) Zähne, Rippen oder Stege (13) ausgebildet sind, die sich in den umlaufenden Deckelrand (11) des Schirmungsdeckels (11) bzw. in die innenliegende Oberfläche (3"a) der Seitenwände (3) in montierter Position einkerben.

4. Hochfrequenzdichtes Gehäuse nach einem der Ansprüche 1 bis 3, **dadurch gekennzeichnet, dass** an dem Deckelrand (11a) quer dazu vorstehende und in Umfangsrichtung versetzt ausgebildete Kontaktzungen ausgebildet sind, die galvanische Kontaktierungsstellen zur inneren Oberfläche (3"a) an den Innenseiten der Seitenwände (3) des schirmenden Gehäuses (1) bilden.

5. Hochfrequenzdichtes Gehäuse nach einem der Ansprüche 1 bis 4, **dadurch gekennzeichnet, dass** die äußeren Kontaktoberflächen (3'a) an den Außenseiten (103a) der Seitenwänden (3) in Steck- und Montagerichtung (M), in der die Schirmungshaube (15) auf das schirmende Gehäuse (1) aufgesetzt wird, zumindest leicht divergierend ausgebildet sind.

6. Hochfrequenzdichtes Gehäuse nach Anspruch 5, **dadurch gekennzeichnet, dass** zumindest bei geraden oder im Wesentlichen gerade verlaufenden Seitenwänden (3; 3', 3") die äußeren Kontaktoberflächen (3'a) im mittleren Seitenwandbereich (3h) einer Seitenwand stärker geneigt sind als in einem Eckbereich (3g) des schirmenden Gehäuses (1).

7. Hochfrequenzdichtes Gehäuse nach einem der Ansprüche 1 bis 6, **dadurch gekennzeichnet, dass** die Haubeninnenwandflächen (15d) der Wand-, Rand- oder Flanschabschnitte (15b) der Schirmungshaube (15) vom Öffnungsbereich (15f) der Schirmungshaube (15) zu deren zentralen Haubenabschnitt (15a) leicht konvergierend ausgebildet sind.

8. Hochfrequenzdichtes Gehäuse nach einem der Ansprüche 1 bis 7, **dadurch gekennzeichnet, dass** zumindest bei geraden oder im Wesentlichen gerade verlaufenden Wand-, Rand- oder Flanschabschnitten (15b) der Schirmungshaube (15) die Haubeninnenwandflächen (15d) unterschiedlich stark gegenüber der Steck- und Montagerichtung (M) geneigt sind, wobei die Größe des Neigungswinkels (α) im mittleren Bereich (15g) der Wand-, Rand- oder Flanschabschnitte (15b) größer ist als im Eckbereich (15h) der Schirmungshaube (15).

9. Hochfrequenzdichtes Gehäuse nach einem der Ansprüche 5 bis 8, **dadurch gekennzeichnet, dass** die geneigten äußeren Kontaktoberflächen (3'a) der Seitenwände (3) in Umfangsrichtung um die Gehäuseöffnung (1a) des schirmenden Gehäuses (1) durch zueinander beabstandete Stege oder Rampen (121) gebildet sind.

10. Hochfrequenzdichtes Gehäuse nach einem der Ansprüche 5 bis 9, **dadurch gekennzeichnet, dass** die geneigten Haubeninnenwandflächen (15d) der Schirmungshaube (15) in Umfangsrichtung um den Öffnungsbereich (15f) der Schirmungshaube (15) durch zueinander beabstandete Stege oder Rampen (121) gebildet sind.

11. Hochfrequenzdichtes Gehäuse nach einem der Ansprüche 1 bis 10, **dadurch gekennzeichnet, dass** der Wand-, Rand- oder Flanschabschnitt (15b) der Schirmungshaube (15) umlaufend geschlossen ist.

12. Hochfrequenzdichtes Gehäuse nach einem der Ansprüche 1 bis 10, **dadurch gekennzeichnet, dass** die Haubenhöhe (15c), also die Höhe der Wand-, Rand- oder Flanschabschnitte (15b) und damit der Überlappungs- und Kontaktierungsbereich zwischen der Schirmungshaube (15) und den Außenseiten (103a) der Seitenwände (3) des schirmenden Gehäuses (1) zumindest 2mm, vorzugsweise zumindest 3mm, 4mm, 5mm, 6mm, 7mm, 8mm, 9mm oder zumindest 10mm groß ist.

13. Hochfrequenzdichtes Gehäuse nach einem der Ansprüche 1 bis 12, **dadurch gekennzeichnet, dass** die Haubenhöhe (15c), also die Höhe der Wand-, Rand- oder Flanschabschnitte (15b) und damit der Überlappungs- und Kontaktierungsbereich zwischen der Schirmungshaube (15) und den Außenseiten (103a) der Seitenwände (3) des schirmenden Gehäuses (1) kleiner als 17,5mm, 15mm, 12,5mm, 10mm oder 7,5mm ist.

14. Hochfrequenzdichtes Gehäuse nach einem der Ansprüche 1 bis 13, **dadurch gekennzeichnet, dass** der Schirmungsdeckel (11) so dimensioniert ist, dass eine Ausbauchung der Seitenwände (3) des schirmenden Gehäuses (1) nach innen unterbunden ist.

15. Hochfrequenzdichtes Gehäuse nach einem der Ansprüche 1 bis 14, **dadurch gekennzeichnet, dass** der Schirmungsdeckel (11) aus einem hochpermeablen Material und die Schirmungshaube (15) aus einem Material mit hoher elektrischer Leitfähigkeit oder umgekehrt bestehen.

16. Hochfrequenzdichtes Gehäuse nach Anspruch 15, **dadurch gekennzeichnet, dass** der Schirmungsdeckel (11) aus Stahlblech und die Schirmungshaube (15) aus Aluminium besteht oder diese Materialien überwiegend umfassen.

17. Hochfrequenzdichtes Gehäuse nach einem der Ansprüche 1 bis 16, **dadurch gekennzeichnet, dass** der Schirmungsdeckel (11) und/oder die Schirmungshaube (15) durch Stanzen und/oder Tiefziehen und/oder Prägen hergestellt sind.

## Claims

1. High-frequency-tight housing, in particular high-frequency-tight antenna outlets or multimedia outlets comprising the following features:
- a shielding housing (1) is provided that comprises a housing opening (1a) to be shielded,
- the shielding housing (1) includes a base (2) and peripheral side walls (3; 3', 3"),
- a shielding cover (11) for shielding the housing opening (1 a) is provided and seals the housing opening (1a),
- a shielding hood (15) is also provided and comprises, in addition to a central hood portion (15a), wall, edge or flange portions (15b) protruding transversely thereto,
- the shielding hood (15) is placed on the housing opening (1a) by its wall, edge or flange portions (15b) such that the wall, edge or flange portions (15b) of the shielding hood (15) overlap the side walls (3) of the shielding housing (1) on the outer face (103a) thereof,
- by means of its hood inner wall surfaces (15d), the shielding hood (15) overlapping the housing opening (1 a) is electrically contacted to outer contact surfaces (3'a) on the outer face (103a) of the side walls (3, 3', 3"), which surfaces are formed on the inner face of the wall, edge or flange portions (15b),
**characterised by** the following further features:
- the shielding cover (11) is inserted into the housing opening (1a) for shielding said housing opening,
- the shielding cover (11) is electrically contacted with the shielding housing (1) on the inner face thereof,
- the shielding cover (11) comprises a cover edge (11 a), between which edge and the inner face (103b) of the side walls (3) there is galvanic contact, at least in the form of galvanic contact points that are provided in a manner offset from one another in the peripheral direction of the shielding cover (11) and by means of which the galvanic contact between the shielding cover (11) and the inner face (103b) of the side walls (3) is generated, and
- the shielding hood (15) is dimensioned such that
a) the side walls (15b) thereof exert a force on the side walls (3) of the shielding housing (1) when assembled in order to increase the contact force between the shielding cover (11) and the housing inner walls (3"a), and/or
b) the shielding hood (15) at least partially counteracts bulging, caused by the shielding cover (11), of the side walls (3) of the shielding housing (1) towards the outside or deforms these side walls (3) back.

2. High-frequency-tight housing according to claim 1, **characterised in that** an inner stepped shoulder (3d) is formed on the inner faces (103b) of the side walls (3) of the shielding housing (1), on which shoulder the shielding cover (11) is mounted, the galvanic contact between the shielding cover (11) and the inner face (103b) of the side walls being produced by means of the stepped shoulder (3d) and/or the inner surface (3"a) that is formed above the stepped shoulder (3d).

3. High-frequency-tight housing according to either claim 1 or claim 2, **characterised in that** teeth, ribs or ridges (13) are formed on the inner surface (3"a) of the side walls (3) and/or on the peripheral cover edge (11 a) of the shielding cover (11), preferably in the insertion and mounting direction (M) of the shielding cover (11) relative to the housing opening (1 a) of the shielding housing (1), which teeth, ribs or ridges notch into the peripheral cover edge (11) of the shielding cover (11) or into the inner surface (3"a) of the side walls (3) when in the assembled position.

4. High-frequency-tight housing according to any of claims 1 to 3, **characterised in that** contact tabs that project transversely to the cover edge (11 a) and are offset around the periphery are formed on said cover edge, and form galvanic contact points to the inner surface (3"a) on the inner faces of the side walls (3) of the shielding housing (1).

5. High-frequency-tight housing according to claims 1 to 4, **characterised in that** the outer contact surfaces (3'a) on the outer faces (103a) of the side walls (3) are designed to diverge at least slightly in the insertion and mounting direction (M) in which the shielding hood (15) is placed on the shielding housing (1).

6. High-frequency-tight housing according to claim 5, **characterised in that** the outer contact surfaces (3'a) in the centre side wall region (3h) of a side wall are more inclined than in a corner region (3g) of the shielding housing (1), at least for side walls (3, 3', 3") that extend straight or substantially straight.

7. High-frequency-tight housing according to any of claims 1 to 6, **characterised in that** the hood inner wall surfaces (15d) of the wall, edge or flange portions (15b) of the shielding hood (15) are designed to slightly converge from the opening region (15f) of the shielding hood (15) towards the central hood portion (15a) thereof.

8. High-frequency-tight housing according to any of claims 1 to 7, **characterised in that** the hood inner wall surfaces (15d) are inclined to different degrees relative to the insertion and mounting direction (M), at least for wall, edge or flange portions (15b) of the shielding hood (15) that extend straight or substantially straight, the size of the angle of inclination (α) being larger in the central region (15g) of the wall, edge or flange portions (15b) than in the corner region (15h) of the shielding hood (15).

9. High-frequency-tight housing according to any of claims 5 to 8, **characterised in that** the inclined outer contact surfaces (3'a) of the side walls (3) in the peripheral direction around the housing opening (1 a) of the shielding housing (1) are formed by ridges or ramps (121) that are spaced apart from one another.

10. High-frequency-tight housing according to any of claims 5 to 9, **characterised in that** the inclined hood inner wall surfaces (15d) of the shielding hood (15) in the peripheral direction around the opening region (15f) of the shielding hood (15) are formed by ridges or ramps (121) that are spaced apart from one another.

11. High-frequency-tight housing according to any of claims 1 to 10, **characterised in that** the wall, edge or flange portion (15b) of the shielding hood (15) is peripherally closed.

12. High-frequency-tight housing according to any of claims 1 to 10, **characterised in that** the hood height (15c), thus the height of the wall, edge or flange portions (15b) and therefore the overlap and contact region between the shielding hood (15) and the outer faces (103a) of the side walls (3) of the shielding housing (1) is at least 2 mm, preferably at least 3 mm, 4 mm, 5 mm, 6 mm, 7 mm, 8 mm, 9 mm or at least 10 mm.

13. High-frequency-tight housing according to any of claims 1 to 12, **characterised in that** the hood height (15c), thus the height of the wall, edge or flange portion (15b) and thus the overlap and contact region between the shielding hood (15) and the outer faces (103a) of the side walls (3) of the shielding housing (1) is smaller than 17.5 mm, 15 mm, 12.5 mm, 10 mm or 7.5 mm.

14. High-frequency-tight housing according to any of claims 1 to 13, **characterised in that** the shielding cover (11) is dimensioned such that the side walls (3) of the shielding housing (1) are prevented from bulging inwards.

15. High-frequency-tight housing according to any of claims 1 to 14, **characterised in that** the shielding cover (11) consists of a highly permeable material and the shielding hood (15) consists of a material having high electrical conductivity or vice versa.

16. High-frequency-tight housing according to claim 15, **characterised in that** the shielding cover (11) consists of sheet steel and the shielding hood (15) consists of aluminium or said cover and hood predominantly comprise these materials.

17. High-frequency-tight housing according to any of claims 1 to 16, **characterised in that** the shielding cover (11) and/or the shielding hood (15) are produced by stamping and/or deep-drawing and/or embossing.

## Revendications

1. Boîtier avec blindage contre les hautes fréquences, en particulier prise d'antenne ou prise multimédia avec blindage contre les hautes fréquences, présentant les éléments suivants :
- il est prévu un boîtier blindant (1) pourvu d'une ouverture (1a) à blinder,
- le boîtier blindant (1) comprend un fond (2) et des parois latérales périphériques (3 ; 3', 3"),
- il est prévu un couvercle de blindage (11) pour blinder l'ouverture de boîtier (1a), qui referme l'ouverture (1a),
- il est en outre prévu un capot de blindage (15) qui comprend, outre une portion de capot centrale (15a), des portions de paroi, de bord ou de bride (15b) qui en font saillie transversalement,
- le capot de blindage (15) est posé sur l'ouverture de boîtier (1a) par ses portions de paroi, de bord ou de bride (15b) de telle sorte que les portions de paroi, de bord ou de bride (15b) du capot de blindage (15) coiffent les parois latérales (3) du boîtier blindant (1) sur leur côté extérieur (103a),
- le capot de blindage (15) qui coiffe l'ouverture de boîtier (1a) a ses surfaces de parois intérieures (15d), réalisées sur le côté intérieur des portions de paroi, de bord ou de bride (15b), en contact électrique avec des surfaces de contact extérieures (3'a) sur le côté extérieur (103a) des parois latérales (3 ; 3', 3"),
**caractérisé par** les autres éléments suivants :
- le couvercle de blindage (11) est mis en place dans l'ouverture de boîtier (1a) pour la blinder,
- le couvercle de blindage (11) est en contact électrique avec le boîtier blindant (1) sur le côté intérieur de celui-ci,
- le couvercle de blindage (11) comprend un bord (11a) entre lequel et le côté intérieur (103b) des parois latérales (3) il existe un contact galvanique au moins sous la forme d'emplacements de contact galvanique prévus mutuellement en décalage en direction périphérique du couvercle de blindage (11), par lesquels le contact galvanique entre le couvercle de blindage (11) et le côté intérieur (103b) des parois latérales (3) est établi, et
- le capot de blindage (15) est dimensionné de telle sorte que
a) ses parois latérales (15b) exercent une force sur les parois latérales (3) du boîtier blindant (1), dans l'état monté, en vue d'augmenter la force de mise en contact entre le couvercle de blindage (11) et les parois intérieures (3"a) du boîtier,
et/ou
b) le capot de blindage (15) s'oppose au moins partiellement à un bombement vers l'extérieur, causé par le couvercle (11), des parois latérales (3) du boîtier de blindage (1), ou remet en forme ces parois latérales (3).

2. Boîtier avec blindage contre les hautes fréquences selon la revendication 1,
**caractérisé en ce que**
un décrochement intérieur (3d) est réalisé sur les côtés intérieurs (103b) des parois latérales (3) du boîtier blindant (1), sur lequel repose le couvercle de blindage (11), la mise en contact galvanique entre le couvercle de blindage (11) et le côté intérieur (103b) des parois latérales (3) étant établie via le décrochement (3d) et/ou via la surface intérieure (3"a) réalisée au-dessus du décrochement (3d).

3. Boîtier avec blindage contre les hautes fréquences selon la revendication 1 ou 2,
**caractérisé en ce que**
des dents, des nervures ou des barrettes (13) sont réalisées sur la surface intérieure (3"a) des parois latérales (3) et/ou sur le bord périphérique (11a) du couvercle (11), de préférence en direction d'enfichage et de montage (M) du couvercle de blindage (11) par rapport à l'ouverture (1a) du boîtier blindant (1), qui viennent s'enfoncer dans le bord périphérique (11) du couvercle de blindage (11) ou dans la surface intérieure (3"a) des parois latérales (3), dans la position montée.

4. Boîtier avec blindage contre les hautes fréquences selon l'une des revendications 1 à 3,
**caractérisé en ce que**
des languettes de contact sont réalisées sur le bord de couvercle (11a) et qui sont réalisées transversalement en saillie et en décalage en direction périphérique, qui forment les emplacements de contact galvanique vers la surface intérieure (3"a) sur les côtés intérieurs des parois latérales (3) du boîtier blindant (1).

5. Boîtier avec blindage contre les hautes fréquences selon l'une des revendications 1 à 4,
**caractérisé en ce que**
les surfaces de contact extérieures (3'a) sur les côtés extérieurs (103a) des parois latérales (3) sont réalisées de manière à diverger au moins légèrement en direction d'enfichage et de montage (M) dans laquelle le capot de blindage (15) est posé sur le boîtier blindant (1).

6. Boîtier avec blindage contre les hautes fréquences selon la revendication 5,
**caractérisé en ce que**
au moins pour des parois latérales (3 ; 3', 3") rectilignes ou sensiblement rectilignes, les surfaces de contact extérieures (3'a) sont inclinées plus fortement dans la zone médiane (3h) d'une paroi latérale que dans une zone de coin (3g) du boîtier blindant (1).

7. Boîtier avec blindage contre les hautes fréquences selon l'une des revendications 1 à 6,
**caractérisé en ce que**
les surfaces de paroi intérieure (15d) des portions de paroi, de bord ou de bride (15b) du capot de blindage (15) sont réalisées de manière à converger légèrement depuis la zone d'ouverture (15f) du capot de blindage (15) vers la portion centrale (15a) du capot.

8. Boîtier avec blindage contre les hautes fréquences selon l'une des revendications 1 à 7,
**caractérisé en ce que**
au moins pour des portions de paroi, de bord ou de bride (15b) rectilignes ou sensiblement rectilignes du capot (15), les surfaces intérieures (15d) du capot présentent des inclinaisons différentes par rapport à la direction d'enfichage et de montage (M), la taille de l'angle d'inclinaison (α) étant plus grande dans la zone médiane (15g) des portions de paroi, de bord ou de bride (15b) que dans la zone de coin (15h) du capot de blindage (15).

9. Boîtier avec blindage contre les hautes fréquences selon l'une des revendications 5 à 8,
**caractérisé en ce que**
les surfaces de contact extérieures inclinées (3'a) des parois latérales (3) sont formées par des barrettes ou des rampes (121) espacées les unes des autres en direction périphérique autour de l'ouverture (1a) du boîtier blindant (1).

10. Boîtier avec blindage contre les hautes fréquences selon l'une des revendications 5 à 9,
**caractérisé en ce que**
les surfaces de paroi intérieures inclinées (15d) du capot de blindage (15) sont formées par des barrettes ou des rampes (121) espacées les unes des autres en direction périphérique autour de la zone d'ouverture (15f) du capot de blindage (15).

11. Boîtier avec blindage contre les hautes fréquences selon l'une des revendications 1 à 10,
**caractérisé en ce que**
la portion de paroi, de bord ou de bride (15b) du capot de blindage (15) est fermée à la périphérie.

12. Boîtier avec blindage contre les hautes fréquences selon l'une des revendications 1 à 10,
**caractérisé en ce que**
la hauteur du capot (15c), donc la hauteur des portions de paroi, de bord ou de bride (15d) et donc la zone de chevauchement et de mise en contact entre le capot de blindage (15) et les côtés extérieurs (103a) des parois latérales (3) du boîtier blindant (1) est d'au moins 2 mm, de préférence d'au moins 3 mm, 4 mm, 5 mm, 6 mm, 7 mm, 8 mm, 9 mm ou d'au moins 10 mm.

13. Boîtier avec blindage contre les hautes fréquences selon l'une des revendications 1 à 12,
**caractérisé en ce que**
la hauteur du capot (15c), donc la hauteur des portions de paroi, de bord ou de bride (15d) et donc la zone de chevauchement et de mise en contact entre le capot de blindage (15) et les côtés extérieurs (103a) des parois latérales (3) du boîtier blindant (1) est inférieure à 17,5 mm, 15 mm, 12,5 mm, 10 mm ou 7,5 mm.

14. Boîtier avec blindage contre les hautes fréquences selon l'une des revendications 1 à 13,
**caractérisé en ce que**
le couvercle de blindage (11) est dimensionné de manière à empêcher un bombement vers l'intérieur des parois latérales (3) du boîtier blindant (1).

15. Boîtier avec blindage contre les hautes fréquences selon l'une des revendications 1 à 14,
**caractérisé en ce que**
le couvercle de blindage (11) est constitué d'un matériau hautement perméable et le capot de blindage (15) est constitué d'un matériau à haute conductivité électrique, ou inversement.

16. Boîtier avec blindage contre les hautes fréquences selon la revendication 15,
**caractérisé en ce que**
le couvercle de blindage (11) est constitué en tôle d'acier et le capot de blindage (15) est constitué en aluminium, ou bien ils comprennent ces matériaux majoritairement.

17. Boîtier avec blindage contre les hautes fréquences selon l'une des revendications 1 à 16,
**caractérisé en ce que**
le couvercle de blindage (11) et/ou le capot de blindage (15) sont réalisés par poinçonnage et/ou emboutissage profond et/ou estampage.
